# EUROPEAN PATENT SPECIFICATION

(11) **EP 1 067 698 B1**
(45) Date of publication and mention of the grant of the patent: **30.11.2005**
(21) Application number: 99202132.9
(22) Date of filing: 30.06.1999
(51) Int. Cl.: H04B 1/10, H03G 3/30

(54) **Receiver comprising intermodulation interference detection means**
Empfänger mit Intermodulationsverzerrungsdetektor
Récepteur avec détecteur de distorsion d'intermodulation

(43) Date of publication of application: 10.01.2001
(73) Proprietor: SIEMENS AKTIENGESELLSCHAFT, 80333 München (DE)
(72) Inventor: Sessink, Franciscus Josephus Alphonsus Maria, 5600 JB Eindhoven (NL)

(56) References cited:
- EP-A- 0 814 568
- US-A- 5 428 824
- US-A- 5 483 694
- US-A- 5 564 094
- PATENT ABSTRACTS OF JAPAN vol. 1995, no. 09, 31 October 1995 (1995-10-31) & JP 07 143025 A (CLARION CO LTD), 2 June 1995 (1995-06-02)
- PAWLAN J: "A TUTORIAL ON INTERMODULATION DISTORTION AND NON-LINEARITY IN RF SYSTEMS" RF DESIGN,US,CARDIFF PUBLISHING CO, ENGLEWOOD,CO, vol. 19, no. 2, page 71-74 XP000557686 ISSN: 0163-321X

## Description

The invention relates to a receiver comprising analog signal processing means and intermodulation interference detection means for detecting intermodulation interference occuring in said analog signal processing means, wherein the analog signal processing means comprises frequency selective means for channel selection.

Such a receiver is on itself known from US patent 4,654,884. The radio receiver disclosed therein, comprises analog signal processing means such as a tuner and an IF amplifier, followed by intermodulation interference detection means included in an automatic gain control circuit. In the intermodulation interference detection means, intermodulation interference is detected by comparing the signal level within the bandwidth of a wanted radio channel with that of radio-channels deviating form the wanted radio-channel by frequency distances allowing intermodulation interferences to occur within the wanted radio-channel. The frequencies of those radio-channels, hereinafter indicated as interfering radio-channels, are derived from the frequency relationship, which is typical for the order of harmonic distortion considered. For instance, for third harmonic intermodulation interferences f0=2f1±f2, in which f0 is the carrier frequency of the wanted channel and in which f1 and f2 are the carrier frequencies of third order harmonic interfering radio-channels. An intermodulation interference indicative signal is generated when the signal level of wanted radio-channel becomes smaller then the signal level of one of the interfering channels.

However, to measure the signal level of an interfering channel, the receiver has to interrupt its correct tuning position, in which a wanted radio-signal is received, and to switch over its tuning to the interfering channels. To avoid the switching of the tuning and the reception of interfering signals during level detection from being heard, the receiver has to be muted. To come to a reliable level detection, the period during which the receiver has to stay tuned to said interfering channel, has to exceed a certain level detection time constant, therewith defining a minimum duration to the mute period. Furthermore, especially when the receiver is used in a fast changing environment, e. g. when being mounted on a moving object such as an automobile, the interference channel level check has to be carried out rather frequently, therewith putting a minimum repetition putting frequency to the mute actions. This all strongly deteriorates the overall receiver performance.

US 5,483,694 discloses a radio receiver with an input circuit which can be supplied with received signals, with a mixer for deriving an IF signal, and with an IF filter, the passband range corresponds to a usable signal range of the received signal, the received signals are amplitude-modified with an auxiliary signal for detecting intermodulation, in the course of which sidebands are generated outside of the useful signal range. The amplitudes of at least one sideband generated by modulation with the auxiliary signal and of the received carrier are compared in the IF signal. In case of deviations from a ratio based on the modulation factor during modulation with the auxiliary signal, a signal indicating the presence of intermodulation is derived.

It is a first object of the present invention to provide a receiver comprising intermodulation interference detection means for detecting intermodulation interference caused by non-linearities in the gain of analog signals when being processed, e. g. in amplifiers, modulators, correlators, etc. and occurring within the bandwidth of a wanted radio channel, which is more accurate and alert than the one disclosed in the above referenced US patent.

A second object of the invention is to provide intermodulation interference detection means which do not necessitate to interrupt processing of the useful radio signal.

A receiver of the above referred type according to the invention is therefore characterized in that the intermodulation interference detection means comprises a level detecting means and a correlator said level detecting means being coupled to said correlator through a first terminal of said correlator, an output of the frequency selective means of the analog signal processing means is coupled to said level detecting means, the intermodulation interference detection means further comprises a signal generator for generating a gain modulation signal, said signal generator being coupled to a gain control terminal of said analog signal processing means as well as to a second terminal of the correlator said correlator supplying an intermodulation interference indicative signal at a detection of differences in relative amplitude variations of the output signal of the level detecting means at the first terminal on the one hand and the gain modulation signal at the second terminal on the other hand.

A variation of the gain of the analog signal processing means will cause level of the useful signal to vary linearly with said gain variation, whereas intermodulation interference components will vary to a second or higher order with said gain variation. According to the invention, this difference in gain variation is used to detect whether the output signal level of the analog signal processing means is predominated by the useful signal or by intermodulation interferences. The occurrence of a signal level at the output of the analog signal processing means varying disproportionally, i. e. to a second or higher order, with a gain variation of the analog signal processing means, is accurately detected in the corre-lator, becoming apparent in the generation of an intermodulation interference indicative signal. Furthermore, the intermodulation interference detection according to the invention is applied during correct tuning at a wanted radio-signal, which, in contrast to the above mentioned known method of intermodulation interference detection, does not require to change tuning and mute the receiver.

A preferred aspect of a receiver according to the invention is characterized in that the signal generator is coupled through inverting means to a modulation signal input terminal of an amplitude modulator following said frequency selective means.

This measure neutralizes modulation of said signal output level with the gain control signal therewith preventing the effect of the gain variation on the signal output level of the analog signal processing means from becoming noticeable in the useful signal.

Preferably, a delay circuit is coupled between the signal generator and said modulation signal input terminal of the amplitude modulator to compensate for the signal delay occurring in the amplifying means.

Another preferred aspect of a receiver according to the invention is characterized in that the signal generator comprises amplitude modulation means to modulate the amplitude of said gain modulation signal with a bandwidth limited pseudo random modulation signal.

By using a bandwidth limited pseudo random modulation signal for the gain control signal the amplitude modulation signal energy is spread over a wide frequency range therewith preventing said signal energy from reaching a hearing threshold level at one or more specific frequencies.

A further suppression of the amplitude modulation signal energy is achieved by limiting the amplitude of the gain modulation signal to 2 dB.

For a cost effective realisation the amplifying means preferably comprise an controllable attenuator preceding a broadband amplifying stage coupled to the gain control terminal of the amplifying means providing a signal attenuation varying with said gain control signal.

In a further preferred aspect the frequency selective means for channel selection comprise a mixing stage followed by an IF circuit for IF channel selection, an output of said IF circuit being coupled through said level detecting means to the first terminal of the correlator.

In another preferred aspect the intermodulation interference indicative signal is visualised by supplying the same to a level indicator coupled to display means for displaying the level of the intermodulation interference indicative signal, allowing the user to take adequate measures, e.g. change tuning or lower the receiver gain.

An automatic change in tuning is obtained by the use of a tuning oscillator supplying a local oscillator signal to the mixing stage being controlled by said processing means to change in frequency when the intermodulation interference indicative signal exceeds a threshold value.

The above and other objects, features and advantages of the present invention will become more apparent from the following description referring to the accompanying drawings, in which a preferred embodiment of the present invention is shown by way of illustrative example.

Figures 1a and 1b are graphical diagrams illustrating the phenomenon of intermodulation interference.
Figure 2 shows the basic concept of intermodulation interference detection according to the invention.
Figure 3 is a block diagram of a receiver according to a preferred embodiment of the present invention.

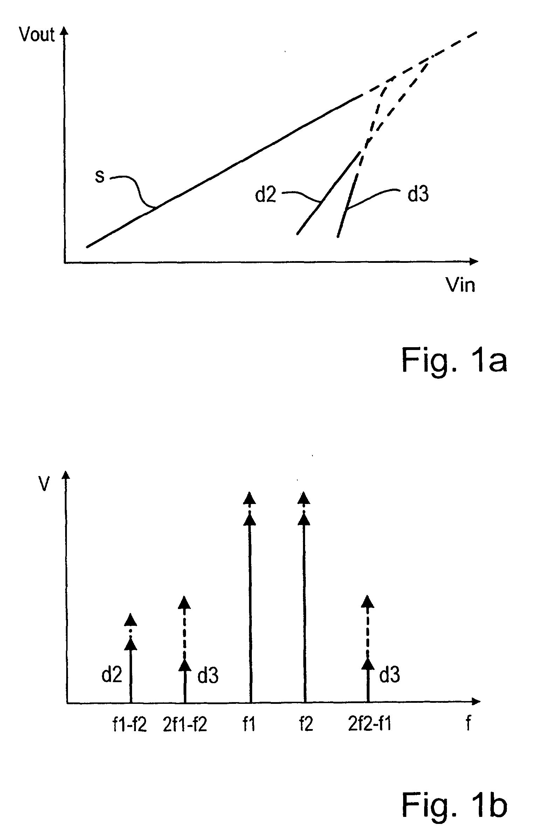

Figures 1a and 1 b are diagrams illustrating the phenomenon of intermodulation interference, in which Figure la shows the differences in amplitude increase between a wanted first order signal s and unwanted second and third order intermodulation products d2 and d3, respectively, as a function of the fieldstrength of the received RF frequency band. These higher order intermodulation products are caused by intermodulation interference between all RF carrier signals within the received RF frequency due to non-linearities in the signal processing within (the amplifiers, mixer and demodulator) of a receiver. Where wanted RF signals vary proportionally with variations in the reception fieldstrength, said higher order harmonic distortion components vary non linearly (i.e. to their order of harmonic distortion) with variations in the reception fieldstrength.
Suppose RF carrier signals f1 and f2 simultaneously occur within the received RF frequency band as shown in Figure 1b. Then intermodulation products occurring nearest to those carrier frequencies f1 and f2, are a second order intermodulation products d2 occurring at f1±f2, and two third order harmonic distortion components d3 occurring at respectively 2f1±f2 and 2f2±f1. Because there are many RF carrier frequencies, it will be clear that the occurrence of unwanted higher order harmonic distortion components within the received RF signal band is in practise unavoidable. The invention, however, makes use of the above difference in amplitude increase between the wanted RF signal and the unwanted higher order intermodulation products to distinguish between wanted signals and unwanted intermodulation products.

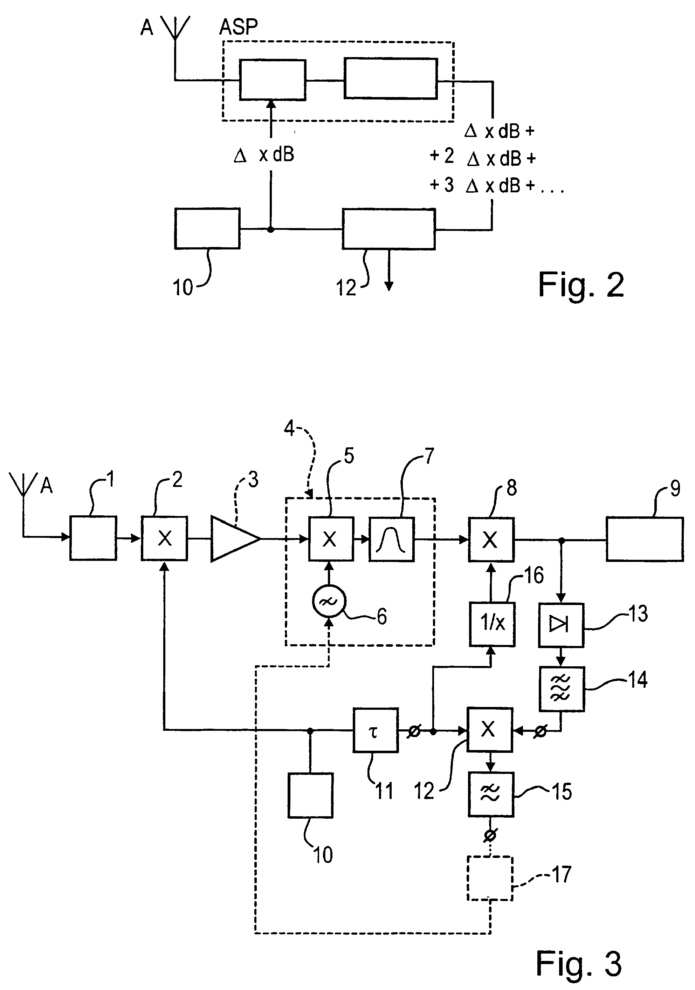

Figure 2 shows the basic concept of a detection according to the invention of intermodulation interference occurring in analog signal processing means ASP, which may comprise various receiver circuitry as will be explained in more detail with reference to Figure 3. The analog signal processing means ASP are gain controlled by means of a gain modulation signal supplied from a signal generator 10 and modulating the amplitude of an RF input signal with an incremental amplitude variation of δx dB. The output signal of the analog signal processing means ASP is channel selected and its level within the selected bandwidth is being measured and supplied to a first input of a correlator 12. A second input of the correlator 12 is supplied by the signal generator 10 with the gain modulation signal. The correlator 12 provides an output signal at the occurrence of differences in amplitude variation between the two signals at its first and second input terminal and increasing in amplitude at an increase of said differences. The greater said differences, the more dominant intermodulation products 2δx, 3δx, .... occur at the second input terminal of the correlator 12. The output signal of the correlator 12 is therewith indicative for the intermodulation interference occurring in the analog signal processing means ASP.

Figure 3 shows a block diagram of a receiver according to a preferred embodiment of the present invention comprising analog signal processing means 1-8 having subsequently connected to antenna means A, an RF input stage 1; controllable RF amplifier means 2, 3, comprising a controllable attenuator 2 and an RF amplifier 3; frequency conversion and selective means 4, comprising a mixer 5 coupled to an IF filter 7, the mixer 5 being supplied with a local oscillator signal from a tunable local oscillator 6; an amplitude modulator 8 followed by IF and audio signal processing means 9. In these analog signal processing means 1-9 the RF receiver input frequency band comprising a wanted RF signal modulated on an RF carrier frequency is being supplied from the antenna means A to the RF input stage 1, comprising a passive, selective matching network, and subsequently broadband amplified in the controllable RF amplifier means 2, 3. An RF to IF conversion of the wanted RF signal is provided in the mixer 5 by mixing the wanted RF signal with a local oscillator signal deviating in frequency from the carrier frequency of the wanted RF signal over a frequency distance equal to the IF frequency. An IF selection of the so converted IF signal is provided in the IF filter 7. Further processing of the IF signal into an audiosignal suitable to be reproduced in audible form is being provided in the IF and audio signal processing means 9. The processing of a wanted RF signal into an audio signal is on itself known and doesn't need further explanation for a proper understanding of the invention.

An output of the amplitude modulator 8 is coupled to intermodulation interference detection means 10-15 comprising level detecting means 13, 14 having a level detector 13 followed by a bandpass filter 14. The bandpass filter 14 is to select the amplitude modulation signal of the output of the level detector 13 and to block DC components eventually occurring therein. An output of the bandpass filter 14 is coupled to a first terminal of a correlator 12. The intermodulation interference detection means 10-15 also comprise a signal generator 10 for generating a gain modulation signal being coupled to a gain control terminal of the controllable attenuator 2 of said controllable RF amplifier means 2, 3 as well as through a delay circuit 11 to a second terminal of the correlator 12. The delay circuit provides a signal delay corresponding to the signal delay occurring in the circuitry 2-4, 8 of the analog signal processing means 1-9. An output of the correlator 12 is coupled through a lowpass filter 15 to an output terminal of the intermodulation interference detection means 10-15 for supplying thereto an intermodulation interference indicative signal.

According to the invention the gain modulation signal is used to vary the attenuation of the attenuator 2 and therewith the overall RF signal gain of the controllable RF amplifier means 2, 3. The amplitude variations of the RF signal at the output of the RF broadband amplifier 4 resulting therefrom pass through the mixer 5 and IF filter 7 to an IF signal input of the amplitude modulator 8. In amplitude modulator 8 the IF signal is being varied in amplitude with the inverse gain modulation signal to remove the first order amplitude variations resulting from the gain modulation in the controllable RF amplifier means 2, 3. This is achieved by supplying the gain modulation signal from the signal generator 10 through a delay circuit 11, compensating for the signal delay occurring in the signal path including circuits 2-4, 8, and a signal inverter 16 providing for an inversion of the gain modulation signal, to a control terminal of the amplitude modulator 8. If the signal level at the output of the IF filter 7, i.e. after being processed (i.e. broadband amplified, frequency converted and selected) in the analog signal processing means 1-8 is predominantly determined by the wanted, i.e. first order, signal, then the amplitude variations caused by the gain modulation signal in the controllable RF amplifier means 2, 3 are completely compensated by the inverse modulation of the IF signal level occurring in the amplitude modulator 8. The level detecting means 13, 14 then provide a zero level signal to the first terminal of the correlator 12. The correlator 12 may in practise be formed by a signal multiplier, which in the given situation causes a zero level output signal to occur, which passes through the lowpass filter 15 to the output of the intermodulation interference detection means 10-15.

However, if the signal level at the output of the IF filter 7 is predominantly determined by unwanted higher order intermodulation products, then the amplitude variations caused by the gain modulation signal in the controllable RF amplifier means 2, 3 of these unwanted higher order intermodulation products are not completely compensated by the inverse modulation of the IF signal level occurring in the amplitude modulator 8. The remaining higher order amplitude variations are being detecting in the level detector 13, selected in the bandpass filter 14, and supplied to the first terminal of the correlator 12. In the correlator 12 these remaining higher order amplitude variations are compared (or multiplied) with the gain modulation signal resulting in a DC signal having a signal level varying with the magnitude of said remaining order amplitude variations. After being selected in the lowpass filter 15, this DC signal is indicative for the overall level of the intermodulation products occurring in the IF signal at the output of the IF filter 7. The intermodulation interference indicative signal at the output terminal of the intermodulation interference detection means 10-15 is used in the receiver of Figure 2 to initiate a change of the tuning frequency of the receiver to another wanted RF carrier frequency. This is achieved by a tuning control signal generator 17 coupled to the output terminal of the intermodulation interference detection means 10-15 supplying a tuning control voltage to the local tuning oscillator 6 when the intermodulation interference indicative signal increases beyond a properly chosen threshold value. The tuning control signal generator 17 may comprise (not shown) RDS signal processing capabilities to allow the receiver to automatically switch tuning to e.g. an alternative frequency (socalled AF switching).

It may also be possible to display the intermodulation interference indicative signal in a numerical or analog intermodulation interference indicator (not shown) indicating quantitatively the overall level of intermodulation products in the received RF signal.

To make the remaining amplitude variations after the compensation in the modulator 8 less noticeable in the reproduced audiosignal, the signal generator 10 may be provided with amplitude modulation means (not shown) to modulate the amplitude of said gain control signal with a bandwidth limited pseudo random modulation signal. The use of such pseudo random modulation signal results in a spectral energy spread of the modulation reducing strongly the audibility of said remaining amplitude variations.

A further reduction in the audibility of amplitude variations is achieved by limiting the relative amplitude variations caused by the gain modulation signal to approximately 2 dB.

The invention is not limited to the forms of implementation as described above. For instance, the measures for reducing the audibility of the gain variation may allow to dispense with the amplitude modulator 8. Furthermore dependent on the required accuracy in the detection of intermodulation interference bandpass filter 14 and/or low pass filter 15 may be dispensed with.

## Claims

1. Receiver comprising analog signal processing means (1-9) and intermodulation interference detection means (10-15) for detecting intermodulation interference occuring in said analog signal processing means wherein the analog signal processing means comprises frequency selective means (4) for channel selection, **characterized in that** the intermodulation interference detection means comprises a level detecting means (13) and a correlator (12), said level detecting means (13) being coupled to said correlator (12) through a first terminal of said correlator (12), an output of the frequency selective means (4) is coupled to said level detecting means (13), the intermodulation interference detection means further comprises a signal generator (10) for generating a gain modulation signal, said signal generator (10) being coupled to a gain control terminal of said analog signal processing means as well as to a second terminal of the correlator (12), said correlator (12) for supplying an intermodulation interference indicative signal at a detection of differences in relative amplitude variations of the output signal of the level detecting means (13) at the first terminal on the one hand and the gain modulation signal at the second terminal on the other hand.

2. Receiver according to claim 1, **characterized in that** said receiver further comprises an inverting means (16), said analog signal processing means further comprises an amplitude modulator (8) following said frequency selective means, the signal generator (10) is coupled through said inverting means (16) to a modulation signal input terminal of said amplitude modulator (8).

3. Receiver according to claim 2, **characterized in that** said intermodulation interference detection means further comprises a delay circuit (11) coupled between the signal generator (10) and said inverting means (16).

4. Receiver according to claim 1, **characterized in that** the signal generator (10) comprises amplitude modulation means to modulate the amplitude of said gain modulation signal with a bandwidth limited pseudo random modulation signal.

5. Receiver according to claims 1 and 4, **characterized in that** said signal generator (10) is adapted to generate a gain modulation signal with an amplitude smaller than 2 dB.

6. Receiver according to one of claims 1 to 5, **characterized in that** the frequency selective means (4) for channel selection comprises a mixing stage (5) followed by an IF circuit for IF channel selection (7), an output of said IF circuit being coupled through said level detecting means (13) to the first terminal of the correlator (12).

7. Receiver according to one of claims 1 to 6, **characterized in that** said receiver further comprises a level indicator coupled to display means for displaying the level of the intermodulation interference indicative

8. Receiver according to claim 6, **characterized in that** the analog signal processing means further comprises a tuning oscillator (6) supplying a local oscillator signal to the mixing stage (5), said intermodulation interference detection means is adapted to control said local oscillator signal to change in frequency when the intermodulation interference indicative signal exceeds a threshold value.

## Patentansprüche

1. Empfänger mit analogen Signalverarbeitungsmitteln (1-9) und Intermodulationsstörungsdetektionsmitteln (10-15) zum Erkennen von Intermodulationsstörungen, die in den analogen Signalverarbeitungsmitteln auftreten, wobei die analogen Signalverarbeitungsmittel frequenzselektive Mittel (4) zur Kanalauswahl umfassen, **dadurch gekennzeichnet, daß** die Intermodulationsstörungsdetektionsmittel ein Pegeldetektionsmittel (13) und einen Korrelator (12) umfassen, wobei das Pegeldetektionsmittel (13) durch einen ersten Anschluß des Korrelators (12) an den Korrelator (12) angekoppelt ist, wobei ein Ausgang des frequenzselektiven Mittels (4) an das Pegeldetektionsmittel (13) angekoppelt ist, wobei die Intermodulationsstörungsdetektionsmittel ferner einen Signalgenerator (10) zum Erzeugen eines Verstärkungsmodulationssignals umfassen, wobei der Signalgenerator (10) an einen Verstärkungsregelanschluß der analogen Signalverarbeitungsmittel sowie an einen zweiten Anschluß des Korrelators (12) angekoppelt ist, wobei der Korrelator (12) zum Liefern eines Intermodulationsstörungen anzeigenden Signals bei einer Detektion von Differenzen relativer Amplitudenschwankungen des Ausgangssignals des Pegeldetektionsmittels (13) an dem ersten Anschluß einerseits und des Verstärkungsmodulationssignals an dem zweiten Anschluß andererseits dient.

2. Empfänger nach Anspruch 1, **dadurch gekennzeichnet, daß** der Empfänger ferner ein invertierendes Mittel (16) umfaßt, wobei die analogen Signalverarbeitungsmittel ferner einen Amplitudenmodulator (8) im Anschluß an das frequenzselektive Mittel umfassen, wobei der Signalgenerator (10) durch das invertierende Mittel (16) an einen Modulationssignaleingangsanschluß des Amplitudenmodulators (8) angekoppelt ist.

3. Empfänger nach Anspruch 2, **dadurch gekennzeichnet, daß** die Intermodulationsstörungsdetektionsmittel ferner eine zwischen den Signalgenerator (10) und das invertierende Mittel (16) gekoppelte Verzögerungsschaltung (11) umfassen.

4. Empfänger nach Anspruch 1, **dadurch gekennzeichnet, daß** der Signalgenerator (10) Amplitudenmodulationsmittel zum Modulieren der Amplitude des Verstärkungsmodulationssignals mit einem bandbreitenbegrenzten Pseudozufallsmodulationssignal umfaßt.

5. Empfänger nach Anspruch 1 und 4, **dadurch gekennzeichnet, daß** der Signalgenerator (10) so ausgelegt ist, daß er ein Verstärkungsmodulationssignal mit einer Amplitude von weniger als 2 dB erzeugt.

6. Empfänger nach einem der Ansprüche 1 bis 5, **dadurch gekennzeichnet, daß** das frequenzselektive Mittel (4) für die Kanalauswahl eine Mischstufe (5) gefolgt durch eine ZF-Schaltung für ZF-Kanalauswahl (7) umfaßt, wobei ein Ausgang der ZF-Schaltung durch das Pegeldetektionsmittel (13) an den ersten Anschluß des Korrelators (12) angekoppelt ist.

7. Empfänger nach einem der Ansprüche 1 bis 6, **dadurch gekennzeichnet, daß** der Empfänger ferner einen an Anzeigemittel angekoppelten Pegelanzeiger zum Anzeigen des Pegels des Intermodulationsstörungen anzeigenden Signals umfaßt.

8. Empfänger nach Anspruch 6, **dadurch gekennzeichnet, daß** die analogen Signalverarbeitungsmittel ferner einen Abstimmoszillator (6) umfassen, der der Mischstufe (5) ein Empfangsoszillatorsignal zuführt, wobei die Intermodulationsstörungsdetektionsmittel dafür ausgelegt sind, das Empfangsoszillatorsignal so zu steuern, daß es seine Frequenz ändert, wenn das Intermodulationsstörungen anzeigende Signal einen Schwellenwert überschreitet.

## Revendications

1. Récepteur comprenant des moyens de traitement de signal analogique (1 à 9) et des moyens de détection d'interférence d'intermodulation (10 à 15) pour détecter une interférence d'intermodulation survenant dans lesdits moyens de traitement de signal analogique, dans lequel les moyens de traitement de signal analogique comprennent un moyen sélectif en fréquence (4) pour la sélection de canal, **caractérisé en ce que** les moyens de détection d'interférence d'intermodulation comprennent un moyen de détection de niveau (13) et un corrélateur (12) et ledit moyen de détection de niveau (13) étant couplé audit corrélateur (12) par l'intermédiaire d'une première borne dudit corrélateur (12), une sortie du moyen sélectif en fréquence (4) est couplée audit moyen de détection de niveau (13), les moyens de détection d'interférence d'intermodulation comprennent en outre un générateur de signaux (10) pour générer un signal de modulation, de gain, ledit générateur de signaux (10) étant couplé à une borne de commande de gain desdits moyens de traitement de signal analogique ainsi qu'à une seconde borne du corrélateur (12), ledit corrélateur (12) étant destiné à délivrer un signal représentatif de l'interférence d'intermodulation lors d'une détection de différences des variations relatives d'amplitude du signal de sortie du moyen de détection de niveau (13) au niveau de la première borne d'une part et du signal de modulation de gain au niveau de la seconde borne d'autre part.

2. Récepteur selon la revendication 1, **caractérisé en ce que** ledit récepteur comprend en outre un moyen d'inversion (16), lesdits moyens de traitement de signal analogique comprennent en outre un modulateur d'amplitude (8) suivant ledit moyen sélectif en fréquence, le générateur de signaux (10) est couplé par l'intermédiaire dudit moyen d'inversion (16) à une borne d'entrée de signal de modulation dudit modulateur d'amplitude (8).

3. Récepteur selon la revendication 2, **caractérisé en ce que** lesdits moyens de détection d'interférence d'intermodulation comprennent en outre un circuit à retard (11) couplé entre le générateur de signaux (10) et ledit moyen d'inversion (16).

4. Récepteur selon la revendication 1, **caractérisé en ce que** le générateur de signaux (10) comprend un moyen de modulation d'amplitude pour moduler l'amplitude dudit signal de modulation de gain à l'aide d'un signal de modulation pseudoaléatoire à largeur de bande limitée.

5. Récepteur selon les revendications 1 et 4, **caractérisé en ce que** ledit générateur de signaux (10) est adapté pour générer un signal de modulation de gain ayant une amplitude inférieure à 2 dB.

6. Récepteur selon l'une des revendications 1 à 5, **caractérisé en ce que** le moyen sélectif en fréquence (4) pour la sélection de canal comprend un étage de mélange (5) suivi par un circuit IF pour la sélection de canal IF (7), une sortie dudit circuit IF étant couplée par l'intermédiaire dudit moyen de détection de niveau (13) à la première borne du corrélateur (12).

7. Récepteur selon l'une des revendications 1 à 6, **caractérisé en ce que** ledit récepteur comprend en outre un indicateur de niveau couplé à un moyen d'affichage pour afficher le niveau du signal représentatif de l'interférence d'intermodulation.

8. Récepteur selon la revendication 6, **caractérisé en ce que** les moyens de traitement de signal analogique comprennent en outre un oscillateur de syntonisation (6) délivrant un signal d'oscillateur local à l'étage de mélange (5), lesdits moyens de détection d'interférence d'intermodulation sont adaptés pour commander ledit signal d'oscillateur local afin de changer de fréquence lorsque le signal représentatif de l'interférence d'intermodulation dépasse une valeur de seuil.
